# EUROPEAN PATENT SPECIFICATION

(11) **EP 4 407 325 B1**
(45) Date of publication and mention of the grant of the patent: **30.07.2025**
(21) Application number: 23153938.8
(22) Date of filing: 30.01.2023
(51) Int. Cl.: G01R 27/14, G01R 31/08, G01R 31/00, G01R 27/16, G01R 31/58

(54) **A METHOD TO DETERMINE THE RESISTANCE IN A CABLE IN A VEHICLE AND A VEHICLE**
VERFAHREN ZUR BESTIMMUNG DES WIDERSTANDS IN EINEM KABEL IN EINEM FAHRZEUG UND FAHRZEUG
PROCÉDÉ POUR DÉTERMINER LA RÉSISTANCE DANS UN CÂBLE DANS UN VÉHICULE ET VÉHICULE

(43) Date of publication of application: 31.07.2024
(73) Proprietor: Ningbo Geely Automobile Research & Development Co. Ltd., Hangzhou Bay New District Ningbo 315336 (CN); Zhejiang Geely Holding Group Co., Ltd., Hangzhou, Zhejiang 310051 (CN)
(72) Inventor: SORANI, Heza, 42151 VÄSTRA FRÖLUNDA (SE)
(74) Representative: Zacco Sweden AB

(56) References cited:
- CN-B- 102 236 082
- KR-A- 20120 130 395
- US-A1- 2013 300 429
- US-A1- 2015 241 489
- US-B2- 10 317 439

## Description

### Technical field

The present disclosure relates to a method to determine the resistance in a cable in a vehicle and a vehicle. More specifically, the disclosure relates to a method to determine the resistance in a cable in a vehicle and a vehicle as defined in the introductory parts of the independent claims.

### Background art

In all electrical and conventional vehicles, the Electrical Control Units (ECUs) and vehicle components rely on electricity. The system current and voltage performances that provided from the power sources by design has an important behavior and impacts for the loads to function fully. Since the automotive industry and almost all OEM's are moving towards increasing electrification of vehicles this will increase the number of electrical components in each vehicle. More and more safety critical functions are relied upon which is further driven by electrification of systems that previously were mainly mechanical as e.g., steering, braking and self-driving systems. This increases the performance demands and safety classifications (ASIL) of the electrical system of vehicles.

An increased current consumption and higher request of power from the power supply system is further a result of the above changes in the industry. In addition, self-driving systems (ADAS) of different levels are being introduced to the marked increasing the demand of high performance of stable direct current from the DCDC, battery and the cable harness resistance and power availability.

In many cases the focus has been to design a system with the sufficient power supply of direct current to delivery and provide robust power rate to the electrical loads with a stable voltage level. But there is a parameter in between the electrical loads and power source that has been to large extent neglected. The cable harness and its resistance/impedances will causing a voltage drop affecting every component.

This voltage drops which is caused by the cable harness resistance can be considered only ones, from the beginning of the project when designing of the power distribution and power supply. The determined cable resistance is based on the material used, cross section area and length. Then this value will be set as a fixed parameter. There is no follow up or any monitoring or detection of the system to analyze how this cable resistance is varying by the time and how this will affect the voltage quality and drops at the system based on the current flowing through it.

Prior art document KR20120130395 discloses an arrangement for estimating the integrity of a steel wire in an aircraft, involving measuring its resistance, compensating for a sensed temperature, and comparing it to an initial resistance value.

There is thus a need for improved methods to handle electrical equipment in vehicles as the electrification of vehicles moves continues.

### Summary

It is an object of the present disclosure to mitigate, alleviate or eliminate one or more of the above-identified deficiencies and disadvantages in the prior art and solve at least the above mentioned problem. According to a first aspect there is provided a method to determine the resistance in a cable in a vehicle, comprising: calculating a cable resistance based on the resistivity of the cable material, the length of the cable and the cable cross sectional area; calculating a corrected resistance value (RT) based on a theoretical temperature of the cable at the current flowing through the cable; measuring a real-time voltage drop between two points along the cable and calculating a measured real-time resistance of the cable; comparing the measured real-time resistance to the corrected resistance value regularly at a predetermined time interval; and providing an error signal if the difference is above a pre-determined threshold value.

The problems of the prior art are thereby addressed. By comparing the measured real-time resistance to the corrected resistance value regularly at a predetermined time interval and providing an error signal if the difference is above a pre-determined threshold value an owner or operator of the vehicle will be warned that the electrical cables in the vehicle electrical system are degraded or even no longer up to security standards.

According to some embodiments, calculating the cable resistance is calculated as the resistivity of cable material multiplied with the length of the cable divided by the cable cross sectional area (*ρ* * L/A [Ω]). A correct estimation of the cable resistance is thereby achieved.

According to some embodiments, calculating the corrected resistance value (R(T)) is calculated as R(T) = R_{Ref} (1+*α*(*T*_{Op} -*T*_{Ref})), wherein T_{Ref} is reference temperature, *α* is a temperature coefficient of resistance for the conductor material of the cables, T_{Op} is the operating temperature during conduction. A correct estimation of the corrected resistance value (R(T)) is thereby achieved.

According to some embodiments, the error signal is provided as a diagnostic trouble code to the vehicle electronic control unit. The error signal can thereby be delivered to the owner or operator of the vehicle using standardized equipment in the vehicle as a infotainments system or the dashboard instrumentation

According to some embodiments, the pre-determined threshold value corresponds to a voltage difference larger than 1.5V. The voltage drop is thus quantified to a be larger than is suitable and the error signal is provided to the owner or user of the vehicle.

According to some embodiments, the method is performed regularly once every year. As cables and their harness age the yearly determination of the cables of the vehicle will provide information to the owner or user about safety issues in the electrical system at a regular yearly basis.

According to some embodiments, the method is performed in connection to an input that the service interval reminder is imminent. If e.g. the service lamp is activated, performance of the method is also initiated so that any problems with the electrical system can be brought to the attention of the service technician when doing the service of vehicle.

According to some embodiments, the method is performed every time the vehicle is turned on. Any problems with the cables of the electrical system will thereby be discovered as soon as the resistance difference is above the pre-determined threshold.

According to a second aspect there is provided a vehicle comprising a power source, an electronic control unit, cables and at least a first measurement point and a second measurement point along the cables, wherein the electronic control unit is arranged to execute the method according to the first aspect.

Effects and features of the second aspect are to a large extent analogous to those described above in connection with the first aspect. Embodiments mentioned in relation to the first aspect are largely compatible with the the second aspect.

The present disclosure will become apparent from the detailed description given below. The detailed description and specific examples disclose preferred embodiments of the disclosure by way of illustration only. Those skilled in the art understand from guidance in the detailed description that changes and modifications may be made within the scope of the disclosure.

Hence, it is to be understood that the herein disclosed disclosure is not limited to the particular component parts of the device described or steps of the methods described since such device and method may vary. It is also to be understood that the terminology used herein is for purpose of describing particular embodiments only, and is not intended to be limiting. It should be noted that, as used in the specification and the appended claim, the articles "a", "an", "the", and "said" are intended to mean that there are one or more of the elements unless the context explicitly dictates otherwise. Thus, for example, reference to "a unit" or "the unit" may include several devices, and the like. Furthermore, the words "comprising", "including", "containing" and similar wordings does not exclude other elements or steps.

### Brief descriptions of the drawings

The above objects, as well as additional objects, features and advantages of the present disclosure, will be more fully appreciated by reference to the following illustrative and non-limiting detailed description of example embodiments of the present disclosure, when taken in conjunction with the accompanying drawings.
Figure 1 shows a vehicle according to an embodiment of the second aspect of the present disclosure. Some components comprised in the vehicle are disclosed in the enlarged dashed circle.
Figure 2 shows flow chart illustrating a method an embodiment of the first aspect of the present disclosure.

### Detailed description

The present disclosure will now be described with reference to the accompanying drawings, in which preferred example embodiments of the disclosure are shown. The disclosure may, however, be embodied in other forms and should not be construed as limited to the herein disclosed embodiments. The disclosed embodiments are provided to fully convey the scope of the disclosure to the skilled person.

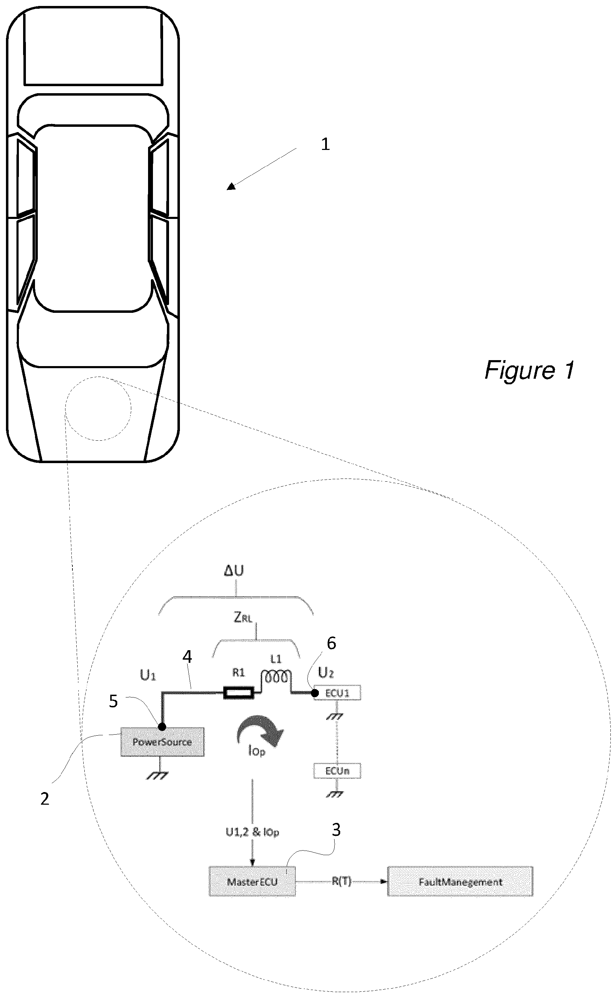

Figure 1 shows a vehicle 1 comprising a power source 2, an electronic control unit 3, cables 4 and at least a first measurement point 5 and a second measurement point 6 along the cables. An electronic control unit 3 is arranged to execute the method according to this disclosure using the measurements from the first measurement point 5 and the second measurement point 6. The bent arrow denoted I_{Op} represents the current flowing to the connected loads ECU1 to ECUn from the power source. The electric current is fed via cables 6 discussed herein with regard to their aging.

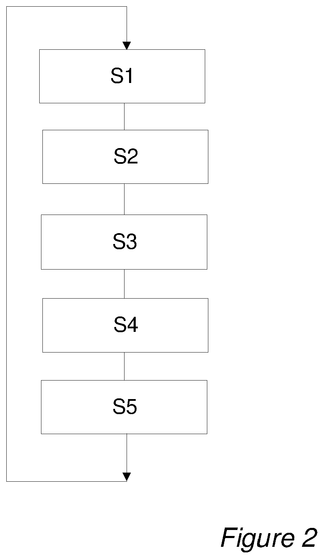

With reference to figures 1 and 2 the first aspect of this disclosure shows a method to determine the resistance in a cable in a vehicle 1, comprising: calculating S1 a cable resistance based on the resistivity of the cable material, the length of the cable and the cable cross sectional area; calculating S2 a corrected resistance value RT based on a theoretical temperature of the cable at the current flowing through the cable; measuring S3 a real-time voltage drop between a first measurement point 5 and a second measurement point 6 along the cable and calculate a measured real-time resistance of the cable; comparing S4 the measured real-time resistance to the corrected resistance value regularly at a predetermined time interval; and providing S5 an error signal if the difference is above a pre-determined threshold value.

The cable resistance of the cable 4 is calculated as the resistivity of cable material multiplied with the length of the cables divided by the cable cross sectional area *ρ* * L/A [Ω]. When calculating the corrected resistance value RT is calculated as R(T) = R_{Ref} (1+*α*(*T*_{Op} -*T*_{Ref})), wherein T_{Ref} is reference temperature, *α* is a temperature coefficient of resistance for the conductor material of the cables, T_{Op} is the operating temperature during conduction.

The error signal is provided as a diagnostic trouble code to the vehicle electronic control unit. In an embodiment of this disclosure the pre-determined threshold value corresponds to a voltage difference larger than 1.5V. The error code can be displayed in any equipment (represented by ECU1 to ECUn in Figure 1) of the vehicle having communication means to communicate with the operator or owner of the vehicle. It could e.g. be displayed on the dashboard display or in the infotainment system, but it could also be communicated to the cloud or via a wireless telecommunication system.

The method disclosed in Figure 2 is preferably performed regularly (indicated by the arrow from S5 to S1 in Figure 2. The method may be performed regularly once every year; in connection to an input that the service interval reminder is imminent; or every time the vehicle is turned on. The more frequent the method is performed, the quicker it is discovered if the cables have degraded below what is considered safe. However, as aging of the cables is a relatively slow process, it may be decided that it is sufficient to perform the method at longer intervals, as e.g. once a year or when the vehicles reaches a service interval.

The person skilled in the art realizes that the present disclosure is not limited to the preferred embodiments described above. The person skilled in the art further realizes that modifications and variations are possible within the scope of the appended claims. Additionally, variations to the disclosed embodiments can be understood and effected by the skilled person in practicing the claimed disclosure, from a study of the drawings, the disclosure, and the appended claims.

## Claims

1. A method to determine the resistance in a cable in a vehicle (1), comprising:
calculating (S1) a cable resistance based on the resistivity of the cable material, the length of the cable and the cable cross sectional area;
calculating (S2) a corrected resistance value (R(T)) based on a theoretical temperature of the cable at the current flowing through the cable;
measuring (S3) a real-time voltage drop between a first measurement point 5 and a second measurement point 6 along the cable and calculating a measured real-time resistance of the cable;
comparing (S4) the measured real-time resistance to the corrected resistance value regularly at a predetermined time interval; and
providing (S5) an error signal if the difference is above a pre-determined threshold value.

2. The method according to claim 1, wherein calculating the cable resistance is calculated as the resistivity of cable material multiplied with the length of the cable(s) divided by the cable cross sectional area (*ρ* * L/A [Ω]).

3. The method according to claim 1 or claim 2, wherein calculating the corrected resistance value (R(T)) is calculated as R(T) = R_{Ref} (1+*α*(*T*_{Op} -*T*_{Ref})), wherein T_{Ref} is reference temperature, *α* is a temperature coefficient of resistance for the conductor material of the cables, T_{Op} is the operating temperature during conduction.

4. The method according to any one of the preceding claims, wherein the error signal is provided as a diagnostic trouble code to the vehicle electronic control unit.

5. The method according to claim 3, wherein the pre-determined threshold value corresponds to a voltage difference larger than 1.5V.

6. The method according to any one of the preceding claims, wherein the method is performed regularly once every year.

7. The method according to any one of claims 1-5, wherein the method is performed in connection to an input that the service interval reminder is imminent.

8. The method according to any one of claims 1-5, wherein the method is performed every time the vehicle is turned on.

9. A vehicle (1) comprising a power source (2), an electronic control unit (3),
cables (4) and at least a first measurement point (5) and a second measurement point (6) along the cables, wherein the electronic control unit (3) is arranged to execute the method according to any one of the preceding claims.

## Patentansprüche

1. Verfahren zur Bestimmung des Widerstands in einem Kabel in einem Fahrzeug (1), umfassend:
Berechnen (S1) eines Kabelwiderstands auf Grundlage der Widerstandsfähigkeit des Kabelmaterials, der Länge des Kabels und der Querschnittsfläche des Kabels;
Berechnen (S2) eines korrigierten Widerstandswerts (R(T)) auf Grundlage einer theoretischen Temperatur des Kabels bei dem Strom, der durch das Kabel fließt;
Messen (S3) eines Echtzeit-Spannungsabfalls zwischen einem ersten Messpunkt 5 und einem zweiten Messpunkt 6 entlang des Kabels und Berechnen eines gemessenen Echtzeit-Widerstands des Kabels;
Vergleichen (S4) des gemessenen Echtzeit-Widerstands mit dem korrigierten Widerstandswert regelmäßig in einem vorbestimmten Zeitintervall; und
Bereitstellen (S5) eines Fehlersignals, wenn die Differenz über einem vorbestimmten Schwellenwert liegt.

2. Verfahren nach Anspruch 1, wobei das Berechnen des Kabelwiderstands als die Widerstandsfähigkeit des Kabelmaterials multipliziert mit der Länge des/der Kabel (s) geteilt durch die Kabelquerschnittsfläche (ρ*L/A[Ω]) berechnet wird.

3. Verfahren nach Anspruch 1 oder Anspruch 2, wobei das Berechnen des korrigierten Widerstandswerts (R(T)) als R(T) =R_{Ref}(1+*α*(*T*_{Op}-_{TRef})) berechnet wird, wobei T_{Ref} die Referenztemperatur ist, *α* ein Temperaturkoeffizient des Widerstands für das Leitermaterial der Kabel ist, T_{Op} die Betriebstemperatur während der Leitung ist.

4. Verfahren nach einem der vorhergehenden Ansprüche, wobei das Fehlersignal als ein Diagnose-Fehlercode der elektronischen Steuereinheit des Fahrzeugs bereitgestellt wird.

5. Verfahren nach Anspruch 3, wobei der vorbestimmte Schwellenwert einer Spannungsdifferenz von mehr als 1,5 V entspricht.

6. Verfahren nach einem der vorhergehenden Ansprüche, wobei das Verfahren regelmäßig einmal jährlich durchgeführt wird.

7. Verfahren nach einem der Ansprüche 1-5, wobei das Verfahren in Verbindung mit einer Eingabe, dass die Wartungsintervallerinnerung bevorsteht, durchgeführt wird.

8. Verfahren nach einem der Ansprüche 1-5, wobei das Verfahren jedes Mal, wenn das Fahrzeug eingeschaltet wird, durchgeführt wird.

9. Fahrzeug (1), umfassend eine Leistungsquelle (2), eine elektronische Steuereinheit (3), Kabel (4) und mindestens einen ersten Messpunkt (5) und einen zweiten Messpunkt (6) entlang der Kabel, wobei die elektronische Steuereinheit (3) dazu ausgelegt ist, das Verfahren nach einem der vorhergehenden Ansprüche auszuführen.

## Revendications

1. Procédé pour déterminer la résistance d'un câble dans un véhicule (1), comprenant :
le calcul (S1) d'une résistance de câble basée sur la résistivité du matériau du câble, la longueur du câble et la section transversale du câble ;
le calcul (S2) d'une valeur de résistance corrigée (R(T)) basée sur une température théorique du câble au niveau du courant circulant dans le câble ;
la mesure (S3) d'une chute de tension en temps réel entre un premier point de mesure (5) et un deuxième point de mesure (6) le long du câble et le calcul d'une résistance mesurée en temps réel du câble ;
la comparaison (S4) de la résistance mesurée en temps réel à la valeur de résistance corrigée régulièrement à un intervalle de temps prédéterminé ; et
la fourniture (S5) d'un signal d'erreur si la différence est supérieure à une valeur seuil prédéterminée.

2. Procédé selon la revendication 1, dans lequel le calcul de la résistance de câble est calculé comme la résistivité du matériau de câble multipliée par la longueur du ou des câbles divisée par la section transversale du câble (ρ*L/A[Ω]).

3. Procédé selon la revendication 1 ou la revendication 2, dans lequel le calcul de la valeur de résistance corrigée (R(T)) est calculé comme R (T) = R_{Ref} (1+α(T_{Op}-T_{Ref})), dans lequel T_{Ref} est la température de référence, α est un coefficient de température de résistance pour le matériau conducteur des câbles, T_{Op} est la température de fonctionnement pendant la conduction.

4. Procédé selon l'une quelconque des revendications précédentes, dans lequel le signal d'erreur est fourni sous la forme d'un code de diagnostic de panne à l'unité de commande électronique de véhicule.

5. Procédé selon la revendication 3, dans lequel la valeur de seuil prédéterminée correspond à une différence de tension supérieure à 1,5 V.

6. Procédé selon l'une quelconque des revendications précédentes, dans lequel le procédé est effectué régulièrement une fois par an.

7. Procédé selon l'une quelconque des revendications 1 à 5, dans lequel le procédé est réalisé en relation avec une entrée indiquant que le rappel d'intervalle de service est imminent.

8. Procédé selon l'une quelconque des revendications 1 à 5, dans lequel le procédé est réalisé à chaque fois que le véhicule est allumé.

9. Véhicule (1) comprenant une source d'alimentation (2), une unité de commande électronique (3), des câbles (4) et au moins un premier point de mesure (5) et un deuxième point de mesure (6) le long des câbles, dans lequel l'unité de commande électronique (3) est agencée pour exécuter le procédé selon l'une quelconque des revendications précédentes.
